# EUROPEAN PATENT APPLICATION

(11) **EP 4 421 138 A1**
(43) Date of publication of application: **28.08.2024**
(21) Application number: 22909273.9
(22) Date of filing: 26.07.2022
(51) Int. Cl.: C09J 7/10, C09J 7/30, H01L 31/048

(54) **ENCAPSULATION FILM AND PHOTOVOLTAIC MODULE**

(30) Priority: 24.12.2021 CN 202111593985
(71) Applicant: Hangzhou First Applied Material Co., Ltd., Hangzhou, Zhejiang 311300 (CN)
(72) Inventor: WEI, Mengjuan, Hangzhou, Zhejiang 311300 (CN); PENG, Ruiqun, Hangzhou, Zhejiang 311300 (CN); HOU, Hongbing, Hangzhou, Zhejiang 311300 (CN); LIN, Weihong, Hangzhou, Zhejiang 311300 (CN)
(74) Representative: HGF
(86) International application number: PCT/CN2022/108006
(87) International publication number: WO 2023/115943

(57) **Abstract**

Provided in the present disclosure are an encapsulation adhesive film and a photovoltaic module. The encapsulation adhesive film includes an infrared high-transmittance adhesive film layer, and an infrared high-reflection adhesive film layer, which is stacked on the infrared high-transmittance adhesive film layer. The light transmittance of the infrared high-transmittance adhesive film layer for light within a wavelength range of 700-1100 nm is greater than 55%; the light transmittance of the infrared high-transmittance adhesive film layer for light within a wavelength range of 400-700 nm is less than 2%; and the reflectivity of the infrared high-reflection adhesive film layer for the light within the wavelength range of 700-1100 nm is greater than 75%. By using the encapsulation adhesive film as an encapsulation adhesive film on a back side of a cell piece, black exterior appearance of the photovoltaic module can be realized so as to reduce light pollution, and sunlight can also be utilized to the maximum extent, such that the overall photoelectric conversion efficiency of the photovoltaic module is improved, thereby improving the efficiency and service life of a solar cell. Furthermore, by applying the encapsulation adhesive film to Building Integrated Photovoltaics (BIPV), both the aesthetics of a building and the efficiency of the photovoltaic module may be taken into consideration.

## Description

### Cross-Reference to Related Application

This application is based upon and claims priority to Chinese Patent Application No. CN202111593985.X filed on December 24, 2021, the disclosure of which is hereby incorporated by reference in its entirety.

### Technical Field

The present disclosure relates to the technical field of photovoltaic modules, and specifically to an encapsulation adhesive film and a photovoltaic module.

### Background

A solar cell body is used to realize the most basic solar cell function, i.e., the conversion of solar energy (light energy) into electrical energy, which involves the utilization of visible-near infrared energy and the redistribution of mid-infrared energy. The energy of solar irradiation is concentrated in ultraviolet, visible light, and infrared regions. The ultraviolet region occupies 7% of the energy, the visible light region occupies 50% of the energy, and the infrared portion accounts for about 43% or so of the energy. Photovoltaic cells mainly absorb and utilize visible light from 400 to 700nm. Infrared light with a wavelength greater than 1100 nm is not used by a cell piece to be converted into electrical energy, but directly converted into heat, resulting in a rapid rise in an internal temperature of a photovoltaic module. Therefore, rational and effective use of sunlight is an effective way to improve the working efficiency of solar cells.

However, in fact, an existing white adhesive film is generally added with white pigments such as silicon oxide, silicon carbide, silicon nitride, titanium oxide, titanium nitride, etc., which may realize infrared high reflection, but cannot realize high transmittance of visible-near-infrared light (0.38-1.1µm). An existing black adhesive film is generally added with carbon black, but the carbon black and the like can only reflect 4% of infrared light in the infrared region and absorb the vast majority of the infrared light, leading to an increase in the temperature of the photovoltaic module.

Therefore, there is an urgent need to develop a new infrared high-reflection adhesive film structure without affecting visible-near-infrared transmittance.

### Summary

The present disclosure is mainly intended to provide an encapsulation adhesive film and a photovoltaic module, to solve a problem of relatively-low photoelectric conversion efficiency of photovoltaic modules in the related art.

In order to implement the above objective, one aspect of the present disclosure provides an encapsulation adhesive film. The encapsulation adhesive film includes an infrared high-transmittance adhesive film layer, and an infrared high-reflection adhesive film layer, which is stacked on the infrared high-transmittance adhesive film layer. The light transmittance of the infrared high-transmittance adhesive film layer for light within a wavelength range of 700-1100 nm is greater than 55%; the light transmittance of the infrared high-transmittance adhesive film layer for light within a wavelength range of 400-700 nm is less than 2%; and the reflectivity of the infrared high-reflection adhesive film layer for the light within the wavelength range of 700-1100 nm is greater than 75%.

Further, the light transmittance of the infrared high-transmittance adhesive film layer for the light within the wavelength range of 700-1100 nm is greater than 58%; and the light transmittance of the infrared high-transmittance adhesive film layer for the light within the wavelength range of 400-700 nm is less than 1%.

Further, the reflectivity of the infrared high-reflection adhesive film layer for the light within the wavelength range of 700-1100 nm is greater than 85%.

Further, the reflectivity of the encapsulation adhesive film for the light within the wavelength range of 700-1100 nm is greater than 70%.

Further, the infrared high-transmittance adhesive film layer includes a pigment. The pigment is selected from any one or more of fullerene and derivatives thereof, a direct fast dye, a direct diazo dye, a direct cross-linking dye, and an azo dye containing complex metal. By weight, the infrared high-transmittance adhesive film layer includes 100 parts of first olefin resin, 0.01-10 parts of the pigment, 0.01-0.1 part of a first coupling agent, 0.01-0.3 parts of a first cross-linking agent, and 0.01-0.3 parts of a first assistant cross-linking agent. The first olefin resin is selected from any one or more of ethylene-vinyl acetate, an ethylene-octene copolymer, an ethylene-α olefin copolymer, an ethylene-methyl methacrylate copolymer, an ethylene-methacrylic acid ionic polymer, and a metallocene-catalyzed ethylene butene copolymer.

Further, by weight, the infrared high-reflection adhesive film layer includes 100 parts of second olefin resin, 5-40 parts of a filler, 0.01-0.1 part of a second coupling agent, 0.01-0.3 parts of a second cross-linking agent, and 0.01-0.3 parts of a second assistant cross-linking agent. The second olefin resin is selected from any one or more of ethylene-vinyl acetate, an ethylene-α olefin copolymer, an ethylene-methyl methacrylate copolymer, an ethylene-methacrylic acid ionic polymer, and a metallocene-catalyzed ethylene butene copolymer. The filler is selected from any one or more of titanium dioxide, talcum powder, silica, aluminum hydroxide, magnesium hydroxide, aluminum oxide, boehmite, mica, kaolin, calcium carbonate, calcium metasilicate, aluminum nitride, and boron nitride; and a particle size of the filler is 0.4-2.0 µm.

Further, the thickness of the infrared high-transmittance adhesive film layer is 80-300 µm. The infrared high-transmittance adhesive film layer is a pre-crosslinked film; and a pre-crosslinked degree of the infrared high-transmittance adhesive film layer is 5-50%.

Further, the thickness of the infrared high-reflection adhesive film layer is 120-500 µm. The infrared high-reflection adhesive film layer is a pre-crosslinked film; and a pre-crosslinked degree of the infrared high-reflection adhesive film layer is 10-70%.

Another aspect of the present disclosure provides a photovoltaic module, including a front transparent encapsulation layer, a first encapsulation adhesive film, a cell piece array, a second encapsulation adhesive film, and a back encapsulation layer. The second encapsulation adhesive film is the encapsulation adhesive film described above.

Further, an infrared high-transmittance adhesive film layer of the encapsulation adhesive film is in contact with a cell piece of the photovoltaic module.

By applying the technical solutions of the present disclosure, the light transmittance of the infrared high-transmittance adhesive film layer of the encapsulation adhesive film provided in the present disclosure for the light within the wavelength range of 700-1100 nm is greater than 55%, and for the light within the wavelength range of 400-700 nm is less than 2%, and the reflectivity of the infrared high-reflection adhesive film layer for the light within the wavelength range of 700-1100 nm is greater than 75%. Therefore, by using the encapsulation adhesive film as an encapsulation adhesive film on a back side of a cell piece, black exterior appearance of the photovoltaic module can be realized so as to reduce light pollution, and sunlight can also be utilized to the maximum extent, such that the overall photoelectric conversion efficiency of the photovoltaic module is improved, thereby improving the efficiency and service life of a solar cell. Furthermore, by applying the encapsulation adhesive film to Building Integrated Photovoltaics (BIPV), both the aesthetics of a building and the efficiency of the photovoltaic module may be taken into consideration.

### Detailed Description of the Embodiments

It is to be noted that the embodiments in the present disclosure and the features in the embodiments may be combined with one another without conflict. The present disclosure will be described below in detail with reference to the embodiments.

As analyzed in the Background, there is a problem in the related art of relatively-low photoelectric conversion efficiency of photovoltaic modules. In order to solve the problem, the present disclosure provides an encapsulation adhesive film and a photovoltaic module.

A typical implementation of the present disclosure provides an encapsulation adhesive film. The encapsulation adhesive film includes an infrared high-transmittance adhesive film layer, and an infrared high-reflection adhesive film layer, which is stacked on the infrared high-transmittance adhesive film layer. The light transmittance of the infrared high-transmittance adhesive film layer for light within a wavelength range of 700-1100 nm is greater than 55%; the light transmittance of the infrared high-transmittance adhesive film layer for light within a wavelength range of 400-700 nm is less than 2%; and the reflectivity of the infrared high-reflection adhesive film layer for the light within the wavelength range of 700-1100 nm is greater than 75%.

The light transmittance of the infrared high-transmittance adhesive film layer of the encapsulation adhesive film provided in the present disclosure for the light within the wavelength range of 700-1100 nm is greater than 55%, and for the light within the wavelength range of 400-700 nm is less than 2%, and the reflectivity of the infrared high-reflection adhesive film layer for the light within the wavelength range of 700-1100 nm is greater than 75%. Therefore, by using the encapsulation adhesive film as an encapsulation adhesive film on a back side of a cell piece, black exterior appearance of the photovoltaic module can be realized so as to reduce light pollution, and sunlight can also be utilized to the maximum extent, such that the overall photoelectric conversion efficiency of the photovoltaic module is improved, thereby improving the efficiency and service life of a solar cell. Furthermore, by applying the encapsulation adhesive film to BIPV, both the aesthetics of a building and the efficiency of the photovoltaic module may be taken into consideration.

Preferably, the light transmittance of the infrared high-transmittance adhesive film layer for the light within the wavelength range of 700-1100 nm is greater than 58%; and preferably, the light transmittance of the infrared high-transmittance adhesive film layer for the light within the wavelength range of 400-700 nm is less than 1%, such that the utilization of the encapsulation adhesive film for the light within the near-infrared wavelength range is further improved, and light pollution is minimized as much as possible.

Preferably, the reflectivity of the infrared high-reflection adhesive film layer for the light within the wavelength range of 700-1100 nm is greater than 85%, such that the overall utilization of the encapsulation adhesive film for the light within the wavelength range of 700-1100 nm is improved.

In an embodiment of the present disclosure, the reflectivity of the encapsulation adhesive film for the light within the wavelength range of 700-1100 nm is greater than 70%.

The encapsulation adhesive film having the above reflectivity further improves a conversion rate of the photovoltaic module for the light.

In an implementation of the present disclosure, the infrared high-transmittance adhesive film layer includes a pigment. The pigment is selected from any one or more of fullerene and derivatives thereof, a direct fast dye, a direct diazo dye, a direct cross-linking dye, and an azo dye containing complex metal. By weight, the infrared high-transmittance adhesive film layer includes 100 parts of first olefin resin, 0.01-10 parts of the pigment, 0.01-0.1 part of a first coupling agent, 0.01-0.3 parts of a first cross-linking agent, and 0.01-0.3 parts of a first assistant cross-linking agent. The pigment is preferably 0.01-0.03 parts. Preferably, the pigment is selected from any one or more of direct black 144, a metal complex dye X55, an azo pigment B27, nigrosine NO.2, perylene black LP32, perylene black L0086, BASF Orasol Black X51, and BASF Paliotol Black L0080. The first olefin resin is selected from any one or more of ethylene-vinyl acetate, an ethylene-octene copolymer, an ethylene-α olefin copolymer, an ethylene-methyl methacrylate copolymer, an ethylene-methacrylic acid ionic polymer, and a metallocene-catalyzed ethylene butene copolymer. Preferably, the first coupling agent is selected from any one or more of triethoxyvinylsilane, vinyltrimethoxysilane, vinyl tris(β-methoxyethoxy)silane, methacryloxypropyltrimethoxysilane, aminopropyltrimethoxysilane, aminopropyltriethoxysilane, aminopropyltriisopropoxysilane. Preferably, the first cross-linking agent is selected from any one or more of mixed compositions of any one or more of isopropyl tert-butyl peroxycarbonate, 2,5-dimethyl-2,5-di(tert-butylperoxy)hexane, 1-bis(tert-butylperoxy)-3,3,5-trimethylcyclohexane, tert-butylperoxy 2-ethylhexyl carbonate, 1,1-di(tert-butylperoxy)-3,3,5-trimethylcyclohexane, 1,1-bis(tert-amylperoxy)-3,3,5-trimethylcyclohexane, 1,1-bis(tert-amylperoxy)cyclohexane, 2,2-bis(tert-butylperoxy)butane, tert-amyl peroxycarbonate, and tert-butyl peroxy-3,5,5-trimethylhexanoate in any proportion. Preferably, the first assistant cross-linking agent is selected from any one or more of trimethallyl isocyanurate, triallyl isocyanurate, triallyl cyanurate, divinylbenzene, diisopropenylbenzene, diallyl phthalate, allyl acrylate, allyl methacrylate, diallyl maleate, diallyl phthalate, pentaerythritol triacrylate, pentaerythritol tetraacrylate, ethoxylated pentaerythitol tetraacrylate, propoxylated pentaerythritol tetraacrylate, trimethylolpropane triacrylate, ethoxylated trimethylolpropane triacrylate, propoxylated trimethylolpropane triacrylate, ethoxylated glycerol triacrylate, glyceryl propoxy triacrylate, trimethylolpropane trimethacrylate, ethoxylated trimethylolpropane trimethacrylate, triethylene glycol dimethacrylate, diethylene glycol dimethacrylate, ethylene dimethacrylate, polyethylene glycol (200) diacrylate, polyethylene glycol (400) diacrylate, polyethylene glycol (600) diacrylate, polyethylene glycol (200) dimethacrylate, polyethylene glycol (400) dimethacrylate, polyethylene glycol (600) dimethacrylate, ethoxylated bisphenol A diacrylate, ethoxylated bisphenol A dimethacrylate, 1,3-butanediol diacrylate, 1,4-butanediol diacrylate, and neopentyl glycol diacrylate.

If more pigment is added, the photovoltaic module is more conducive to present black exterior appearance. However, the excessive pigment leads to a reduction in the light transmittance of the infrared high-transmittance adhesive film layer. In the present disclosure, the content of the pigment in the infrared high-transmittance adhesive film layer is preferred such that the light transmittance of the infrared high-transmittance adhesive film layer for the light within the wavelength range of 700-1100 nm can be improved on the basis of the fact that the infrared high-transmittance adhesive film layer is a black adhesive film, and the conversion of absorbed light into heat by the black adhesive film is minimized, thereby reducing the risk of temperature rise in the photovoltaic module. Preferably, the first coupling agent, the first cross-linking agent, and the first assistant cross-linking agent are conductive to improving a cross-linking effect of the first olefin resin. Definitely, a person skilled in the art may also select other suitable kinds of first coupling agents, first cross-linking agents, and first assistant cross-linking agents, which are not described herein again.

In an implementation of the present disclosure, by weight, the infrared high-reflection adhesive film layer includes 100 parts of second olefin resin, 5-40 parts of a filler, 0.01-0.1 part of a second coupling agent, 0.01-0.3 parts of a second cross-linking agent, and 0.01-0.3 parts of a second assistant cross-linking agent. The second olefin resin is selected from any one or more of ethylene-vinyl acetate, an ethylene-α olefin copolymer, an ethylene-methyl methacrylate copolymer, an ethylene-methacrylic acid ionic polymer, and a metallocene-catalyzed ethylene butene copolymer. The filler is selected from any one or more of titanium dioxide, talcum powder, silica, aluminum hydroxide, magnesium hydroxide, aluminum oxide, boehmite, mica, kaolin, calcium carbonate, calcium metasilicate, aluminum nitride, and boron nitride; and a particle size of the filler is 0.4-2.0 µm, and preferably is 0.7-2.0 µm. Preferably, the second coupling agent is selected from any one or more of triethoxyvinylsilane, vinyltrimethoxysilane, vinyl tris(β-methoxyethoxy)silane, methacryloxypropyltrimethoxysilane, aminopropyltrimethoxysilane, aminopropyltriethoxysilane, aminopropyltriisopropoxysilane. Preferably, the second cross-linking agent is selected from any one or more of mixed compositions of any one or more of isopropyl tert-butyl peroxycarbonate, 2,5-dimethyl-2,5-di(tert-butylperoxy)hexane, 1-bis(tert-butylperoxy)-3,3,5-trimethylcyclohexane, tert-butylperoxy 2-ethylhexyl carbonate, 1,1-di(tert-butylperoxy)-3,3,5-trimethylcyclohexane, 1,1-bis(tert-amylperoxy)-3,3,5-trimethylcyclohexane, 1,1-bis(tert-amylperoxy)cyclohexane, 2,2-bis(tert-butylperoxy)butane, tert-amyl peroxycarbonate, and tert-butyl peroxy-3,5,5-trimethylhexanoate in any proportion. Preferably, the second assistant cross-linking agent is selected from any one or more of trimethallyl isocyanurate, triallyl isocyanurate, triallyl cyanurate, divinylbenzene, diisopropenylbenzene, diallyl phthalate, allyl acrylate, allyl methacrylate, diallyl maleate, diallyl phthalate, pentaerythritol triacrylate, pentaerythritol tetraacrylate, ethoxylated pentaerythitol tetraacrylate, propoxylated pentaerythritol tetraacrylate, trimethylolpropane triacrylate, ethoxylated trimethylolpropane triacrylate, propoxylated trimethylolpropane triacrylate, ethoxylated glycerol triacrylate, glyceryl propoxy triacrylate, trimethylolpropane trimethacrylate, ethoxylated trimethylolpropane trimethacrylate, triethylene glycol dimethacrylate, diethylene glycol dimethacrylate, ethylene dimethacrylate, polyethylene glycol (200) diacrylate, polyethylene glycol (400) diacrylate, polyethylene glycol (600) diacrylate, polyethylene glycol (200) dimethacrylate, polyethylene glycol (400) dimethacrylate, polyethylene glycol (600) dimethacrylate, ethoxylated bisphenol A diacrylate, ethoxylated bisphenol A dimethacrylate, 1,3-butanediol diacrylate, 1,4-butanediol diacrylate, and neopentyl glycol diacrylate.

The filler in the infrared high-reflection adhesive film layer of the present disclosure makes the infrared high-reflection adhesive film layer a white adhesive film, so as to facilitate the improvement of the reflectivity of the encapsulation adhesive film to irradiated light, and titanium dioxide with a large particle size has higher near-infrared reflectivity, such that the near-infrared reflectivity of the preferred titanium dioxide within the above particle size range is higher. Accumulation is caused when more filler is added, an effective specific surface area achieving a sunlight reflection effect decrease, and the overall reflectivity of the encapsulation adhesive film reduces accordingly, such that 5-15 parts of the filler is more conductive to improving the reflectivity of the encapsulation adhesive film to the irradiated light. Preferably, the second coupling agent, the second cross-linking agent, and the second assistant cross-linking agent are conductive to improving a cross-linking effect of the second olefin resin. Definitely, a person skilled in the art may also select other suitable kinds of second coupling agents, second cross-linking agents, and second assistant cross-linking agents, which are not described herein again.

The thickness of the infrared high-transmittance adhesive film layer has a certain impact on the light transmittance of the irradiated light, and the thickness of the infrared high-transmittance adhesive film layer is 80-300 µm, such that the overall light transmittance of the infrared high-transmittance adhesive film layer for the light within the wavelength range of 700-1100 nm is improved. The infrared high-transmittance adhesive film layer is preferably a pre-crosslinked film, and a pre-crosslinked degree of the infrared high-reflection adhesive film layer is preferably 5-50%. Therefore, the risk of spillage of the infrared high-transmittance adhesive film layer onto a front side of a cell is avoided, thereby guaranteeing desirable laminated appearance of the photovoltaic module and avoiding unnecessary losses of positive power of the photovoltaic module. When the infrared high-transmittance adhesive film layer has no spillage risk, if the pre-crosslinked degree of the infrared high-reflection adhesive film layer is lower, it is more conductive to minimizing or avoiding cracking or hidden cracking of a cell piece.

Preferably, the thickness of the infrared high-reflection adhesive film layer is 120-500 µm, such that the overall reflectivity of the infrared high-reflection adhesive film layer for the light within the wavelength range of 700-1100 nm is improved. The infrared high-reflection adhesive film layer is preferably a pre-crosslinked film, and a pre-crosslinked degree of the infrared high-reflection adhesive film layer is preferably 10-70%. Therefore, the risk of spillage of the infrared high-reflection adhesive film layer due to the flowing of the infrared high-reflection adhesive film layer onto the front side of the cell is avoided, thereby guaranteeing desirable laminated appearance of the photovoltaic module and avoiding unnecessary losses of positve power of the photovoltaic module.

Preferably, the pre-crosslinked degree of the infrared high-transmittance adhesive film layer is lower than the pre-crosslinked degree of the infrared high-reflection adhesive film layer, such that the desirable appearance of the photovoltaic module and the integrity of the cell are both taken into consideration.

Another typical implementation of the present disclosure provides a photovoltaic module, including a front transparent encapsulation layer, a first encapsulation adhesive film layer, a cell piece array, a second encapsulation adhesive film layer, and a back encapsulation layer. The second encapsulation adhesive film layer is the encapsulation adhesive film described above.

By using the encapsulation adhesive film as the second encapsulation adhesive film layer on a back side of a cell piece array, sunlight can be utilized to the maximum extent, such that the overall photoelectric conversion efficiency of the photovoltaic module is improved, thereby improving the efficiency and service life of a solar cell.

Preferably, an infrared high-transmittance adhesive film layer of the encapsulation adhesive film is in contact with a cell piece of the photovoltaic module. One part of sunlight irradiating on the encapsulation adhesive film is absorbed by the cell piece via the infrared high-transmittance adhesive film layer, and the other part of the sunlight is formed into reflected light by the infrared high-reflection adhesive film layer, and then the reflected light is reflected again to the encapsulation adhesive film through an inner surface of a backboard and reaches the cell piece after passing through the infrared high-transmittance adhesive film layer, such that the overall reflectivity of the encapsulation adhesive film is improved, thereby improving the overall photovoltaic conversion efficiency of the photovoltaic module.

The beneficial effects of the present disclosure are further described below with reference to the specific embodiments and comparative examples.

### Embodiment 1

A formula of an infrared high-transmittance adhesive film layer E1-1 included: 100 parts of an ethylene-octene copolymer, 0.01 part of an azo pigment B27, 0.01 part of vinyltrimethoxysilane, 0.01 part of isopropyl tert-butyl peroxycarbonate, and 0.01 part of propoxylated pentaerythritol tetraacrylate.

A formula of an infrared high-reflection adhesive film layer E1-2 included: 100 parts of ethylene-vinyl acetate, 5 parts of titanium dioxide (with a particle size being 1 µm), 0.01 part of vinyltrimethoxysilane, 0.01 part of isopropyl tert-butyl peroxycarbonate, and 0.01 part of propoxylated pentaerythritol tetraacrylate.

Multi-layer coextrusion was performed on the E1-1 and the E1-2 to prepare a two-layer photovoltaic encapsulation adhesive film, recorded as E1; the thickness of the infrared high-transmittance adhesive film layer E1-1 of the obtained encapsulation adhesive film was 0.2 mm, and the thickness of the infrared high-reflection adhesive film layer E1-2 was 0.3 mm; and a pre-crosslinked degree of the infrared high-transmittance adhesive film layer E1-1 was 10%, and a pre-crosslinked degree of the infrared high-reflection adhesive film layer E1-2 was 15%.

### Embodiment 2

Differences between Embodiment 2 and Embodiment 1 lied in that, a formula of an infrared high-transmittance adhesive film layer E2-1 included: 100 parts of the ethylene-octene copolymer, 0.03 parts of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E2-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E2-1 and the E2-2 to prepare a two-layer photovoltaic encapsulation adhesive film, recorded as E2; the thickness of the infrared high-transmittance adhesive film layer E2-1 of the obtained encapsulation adhesive film was 0.2 mm, and the thickness of the infrared high-reflection adhesive film layer E2-2 was 0.3 mm; and a pre-crosslinked degree of the infrared high-transmittance adhesive film layer E2-1 was 10%, and a pre-crosslinked degree of the infrared high-reflection adhesive film layer E2-2 was 15%.

### Embodiment 3

Differences between Embodiment 3 and Embodiment 1 lied in that, a formula of an infrared high-transmittance adhesive film layer E3-1 included: 100 parts of the ethylene-octene copolymer, 10 parts of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E3-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E3-1 and the E3-2 to prepare a two-layer photovoltaic encapsulation adhesive film, recorded as E3; the thickness of the infrared high-transmittance adhesive film layer E3-1 of the obtained encapsulation adhesive film was 0.2 mm, and the thickness of the infrared high-reflection adhesive film layer E3-2 was 0.3 mm; and a pre-crosslinked degree of the infrared high-transmittance adhesive film layer E3-1 was 10%, and a pre-crosslinked degree of the infrared high-reflection adhesive film layer E3-2 was 15%.

### Embodiment 4

Differences between Embodiment 4 and Embodiment 1 lied in that, a formula of an infrared high-transmittance adhesive film layer E4-1 included: 100 parts of the ethylene-octene copolymer, 0.01 part of perylene black L0086, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E4-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E4-1 and the E4-2 to prepare a two-layer photovoltaic encapsulation adhesive film, recorded as E4; the thickness of the infrared high-transmittance adhesive film layer E4-1 of the obtained encapsulation adhesive film was 0.2 mm, and the thickness of the infrared high-reflection adhesive film layer E4-2 was 0.3 mm; and a pre-crosslinked degree of the infrared high-transmittance adhesive film layer E4-1 was 10%, and a pre-crosslinked degree of the infrared high-reflection adhesive film layer E4-2 was 15%.

### Embodiment 5

Differences between Embodiment 5 and Embodiment 1 lied in that, a formula of an infrared high-transmittance adhesive film layer E5-1 included: 100 parts of the ethylene-octene copolymer, 0.01 part of BASF Paliotol Black L0080, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E5-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E5-1 and the E5-2 to prepare a two-layer photovoltaic encapsulation adhesive film, recorded as E5; the thickness of the infrared high-transmittance adhesive film layer E5-1 of the obtained encapsulation adhesive film was 0.2 mm, and the thickness of the infrared high-reflection adhesive film layer E5-2 was 0.3 mm; and a pre-crosslinked degree of the infrared high-transmittance adhesive film layer E5-1 was 10%, and a pre-crosslinked degree of the infrared high-reflection adhesive film layer E5-2 was 15%.

### Embodiment 6

Differences between Embodiment 6 and Embodiment 1 lied in that, a formula of an infrared high-transmittance adhesive film layer E6-1 included: 100 parts of the ethylene-octene copolymer, 5 parts of the azo pigment B27, 0.05 parts of the vinyltrimethoxysilane, 0.2 parts of the isopropyl tert-butyl peroxycarbonate, and 0.2 parts of the propoxylated pentaerythritol tetraacrylate.

A formula of an infrared high-reflection adhesive film layer E6-2 included: 100 parts of the ethylene-vinyl acetate, 25 parts of the titanium dioxide (with the particle size being 1 µm), 0.05 part of the vinyltrimethoxysilane, 0.2 part of the isopropyl tert-butyl peroxycarbonate, and 0.2 part of the propoxylated pentaerythritol tetraacrylate.

Multi-layer coextrusion was performed on the E6-1 and the E6-2 to prepare a two-layer photovoltaic encapsulation adhesive film, recorded as E6; the thickness of the infrared high-transmittance adhesive film layer E6-1 of the obtained encapsulation adhesive film was 0.2 mm, and the thickness of the infrared high-reflection adhesive film layer E6-2 was 0.3 mm; and a pre-crosslinked degree of the infrared high-transmittance adhesive film layer E6-1 was 20%, and a pre-crosslinked degree of the infrared high-reflection adhesive film layer E6-2 was 40%.

### Embodiment 7

Differences between Embodiment 7 and Embodiment 1 lied in that, a formula of an infrared high-transmittance adhesive film layer E7-1 included: 100 parts of the ethylene-octene copolymer, 10 parts of the azo pigment B27, 0.1 part of the vinyltrimethoxysilane, 0.3 part of the isopropyl tert-butyl peroxycarbonate, and 0.8 part of the propoxylated pentaerythritol tetraacrylate.

A formula of an infrared high-reflection adhesive film layer E7-2 included: 100 parts of the ethylene-vinyl acetate, 40 parts of the titanium dioxide (with the particle size being 1 µm), 0.1 part of the vinyltrimethoxysilane, 0.3 part of the isopropyl tert-butyl peroxycarbonate, and 0.3 part of the propoxylated pentaerythritol tetraacrylate.

Multi-layer coextrusion was performed on the E7-1 and the E7-2 to prepare a two-layer photovoltaic encapsulation adhesive film, recorded as E7; the thickness of the infrared high-transmittance adhesive film layer E7-1 of the obtained encapsulation adhesive film was 0.2 mm, and the thickness of the infrared high-reflection adhesive film layer E7-2 was 0.3 mm; and a pre-crosslinked degree of the infrared high-transmittance adhesive film layer E7-1 was 50%, and a pre-crosslinked degree of the infrared high-reflection adhesive film layer E7-2 was 50%.

### Embodiment 8

Differences between Embodiment 8 and Embodiment 1 lied in that, a formula of an infrared high-transmittance adhesive film layer E8-1 included: 100 parts of an ethylene-α olefin copolymer, 0.01 part of the azo pigment B27, 0.1 part of methacryloxypropyltrimethoxysilane, 0.3 parts of 2,5-dimethyl-2,5-di(tert-butylperoxy)hexane, and 0.3 parts of ethoxylated glycerol triacrylate.

A formula of an infrared high-reflection adhesive film layer E8-2 included: 100 parts of an ethylene-methacrylic acid ionic polymer, 40 parts of aluminum oxide (with a particle size being 1 µm), 0.1 part of vinyl tris(β-methoxyethoxy)silane, 0.3 parts of 2,2-bis(tert-butylperoxy)butane, and 0.3 parts of polyethylene glycol (200) diacrylate.

Multi-layer coextrusion was performed on the E8-1 and the E8-2 to prepare a two-layer photovoltaic encapsulation adhesive film, recorded as E8; the thickness of the infrared high-transmittance adhesive film layer E8-1 of the obtained encapsulation adhesive film was 0.2 mm, and the thickness of the infrared high-reflection adhesive film layer E8-2 was 0.3 mm; and a pre-crosslinked degree of the infrared high-transmittance adhesive film layer E8-1 was 10%, and a pre-crosslinked degree of the infrared high-reflection adhesive film layer E8-2 was 15%.

### Embodiment 9

Differences between Embodiment 9 and Embodiment 1 lied in that, a formula of an infrared high-transmittance adhesive film layer E9-1 included: 100 parts of the ethylene-octene copolymer, 0.01 part of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E9-2 included: 100 parts of the ethylene-vinyl acetate, 5 parts of the titanium dioxide (with the particle size being 0.7 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E9-1 and the E9-2 to prepare a two-layer photovoltaic encapsulation adhesive film, recorded as E9; the thickness of the infrared high-transmittance adhesive film layer E9-1 of the obtained encapsulation adhesive film was 0.2 mm, and the thickness of the infrared high-reflection adhesive film layer E9-2 was 0.3 mm; and a pre-crosslinked degree of the infrared high-transmittance adhesive film layer E9-1 was 10%, and a pre-crosslinked degree of the infrared high-reflection adhesive film layer E9-2 was 15%.

### Embodiment 10

Differences between Embodiment 10 and Embodiment 1 lied in that, a formula of an infrared high-transmittance adhesive film layer E10-1 included: 100 parts of the ethylene-octene copolymer, 0.01 part of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E10-2 included: 100 parts of the ethylene-vinyl acetate, 5 parts of the titanium dioxide (with the particle size being 0.4 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E10-1 and the E10-2 to prepare a two-layer photovoltaic encapsulation adhesive film, recorded as E10; the thickness of the infrared high-transmittance adhesive film layer E10-1 of the obtained encapsulation adhesive film was 0.2 mm, and the thickness of the infrared high-reflection adhesive film layer E10-2 was 0.3 mm; and a pre-crosslinked degree of the infrared high-transmittance adhesive film layer E10-1 was 10%, and a pre-crosslinked degree of the infrared high-reflection adhesive film layer E10-2 was 15%.

### Embodiment 11

Differences between Embodiment 11 and Embodiment 1 lied in that, a formula of an infrared high-transmittance adhesive film layer E11-1 included: 100 parts of the ethylene-octene copolymer, 0.01 part of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E 11-2 included: 100 parts of the ethylene-vinyl acetate, 5 parts of the titanium dioxide (with the particle size being 2 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E11-1 and the E11-2 to prepare a two-layer photovoltaic encapsulation adhesive film, recorded as E11; the thickness of the infrared high-transmittance adhesive film layer E11-1 of the obtained encapsulation adhesive film was 0.2 mm, and the thickness of the infrared high-reflection adhesive film layer E11-2 was 0.3 mm; and a pre-crosslinked degree of the infrared high-transmittance adhesive film layer E11-1 was 10%, and a pre-crosslinked degree of the infrared high-reflection adhesive film layer E11-2 was 15%.

### Embodiment 12

Differences between Embodiment 12 and Embodiment 1 lied in that, a formula of an infrared high-transmittance adhesive film layer E12-1 included: 100 parts of the ethylene-octene copolymer, 0.01 part of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E12-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E12-1 and the E12-2 to prepare a two-layer photovoltaic encapsulation adhesive film, recorded as E12; the thickness of the infrared high-transmittance adhesive film layer E12-1 of the obtained encapsulation adhesive film was 0.08mm, and the thickness of the infrared high-reflection adhesive film layer E12-2 was 0.12mm; and a pre-crosslinked degree of the infrared high-transmittance adhesive film layer E12-1 was 10%, and a pre-crosslinked degree of the infrared high-reflection adhesive film layer E12-2 was 15%.

### Embodiment 13

Differences between Embodiment 13 and Embodiment 1 lied in that, a formula of an infrared high-transmittance adhesive film layer E13-1 included: 100 parts of the ethylene-octene copolymer, 0.01 part of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E13-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E13-1 and the E13-2 to prepare a two-layer photovoltaic encapsulation adhesive film, recorded as E13; the thickness of the infrared high-transmittance adhesive film layer E13-1 of the obtained encapsulation adhesive film was 0.3mm, and the thickness of the infrared high-reflection adhesive film layer E13-2 was 0.5mm; and a pre-crosslinked degree of the infrared high-transmittance adhesive film layer E13-1 was 10%, and a pre-crosslinked degree of the infrared high-reflection adhesive film layer E13-2 was 15%.

### Embodiment 14

Differences between Embodiment 14 and Embodiment 1 lied in that, a formula of an infrared high-transmittance adhesive film layer E14-1 included: 100 parts of the ethylene-vinyl acetate, 0.01 part of the azo pigment B27, 0.01 part of the vinyltrimethoxysilane, 0.01 part of the isopropyl tert-butyl peroxycarbonate, and 0.01 part of the propoxylated pentaerythritol tetraacrylate.

A formula of an infrared high-reflection adhesive film layer E14-2 included: 100 parts of the ethylene-vinyl acetate, 5 parts of the titanium dioxide (with the particle size being 1 µm), 0.01 part of the vinyltrimethoxysilane, 0.01 part of the isopropyl tert-butyl peroxycarbonate, and 0.01 part of the propoxylated pentaerythritol tetraacrylate.

Multi-layer coextrusion was performed on the E14-1 and the E14-2 to prepare a two-layer photovoltaic encapsulation adhesive film, recorded as E14; the thickness of the infrared high-transmittance adhesive film layer E14-1 of the obtained encapsulation adhesive film was 0.2 mm, and the thickness of the infrared high-reflection adhesive film layer E14-2 was 0.3 mm; and a pre-crosslinked degree of the infrared high-transmittance adhesive film layer E14-1 was 10%, and a pre-crosslinked degree of the infrared high-reflection adhesive film layer E14-2 was 15%.

Photovoltaic module: black photovoltaic modules PV-1-PV-14 were prepared by sequentially placing tempering glass, conventional transparent encapsulation adhesive films, crystalline silicon cell pieces, the encapsulation adhesive films E1-E14 (the infrared high-transmittance adhesive film layers E1-1-E14-1 of the encapsulation adhesive films E1-E14 are in contact with the crystalline silicon cell pieces, respectively), and transparent backboards from top to bottom, and then laminating the above by a laminating machine at 145 °C.

Comparative example 1: a corresponding black photovoltaic module PV-D1 was prepared by sequentially placing the tempering glass, the conventional transparent encapsulation adhesive film, the crystalline silicon cell piece, a conventional transparent EVA encapsulation adhesive film F806PS, and a black backboard BEC306HB from top to bottom, and then laminating the above by the laminating machine at 145°C.

The transmission and reflection performance of the infrared high-transmittance adhesive film layers E1-1-E14-1, infrared high-reflection adhesive film layers E1-2-E14-2, and encapsulation adhesive films E1-E14 correspondingly obtained in Embodiments 1 to 14 were respectively tested, and test results were listed in Table 1.

### Test method:

Light transmittance testing: determination was performed according to the Standard GBIT 2410-2008, and the light transmittance of the infrared high-transmittance adhesive film layers E1-1-E14-1 was determined by using an ultraviolet-visible spectrophotometer.

Reflectivity testing: determination was performed according to the Standard GBIT 29848, and the reflectivity of the infrared high-reflection adhesive film layers E1-2-E14-2 and encapsulation adhesive films E1-E14 was determined by using the ultraviolet-visible spectrophotometer.

**Table 1**

| | Light transmittance/% of 700-1100 nm | Light transmittance/% of 400-700 nm | Reflectivity/% of 700-1100 nm |
|---|---|---|---|
| E1-1 | 78 | 1.8 | - |
| E1-2 | - | - | 87.5 |
| E1 | - | - | 84.5 |
| E2-1 | 75 | 1.6 | - |
| E2-2 | - | - | 87.4 |
| E2 | - | - | 82.5 |
| E3-1 | 55.2 | 0.2 | - |
| E3-2 | - | - | 87.5 |
| E3 | - | - | 70.3 |
| E4-1 | 78.1 | 1.9 | - |
| E4-2 | - | - | 87.4 |
| E4 | - | - | 84.6 |
| E5-1 | 77.9 | 1.7 | - |
| E5-2 | - | - | 87.6 |
| E5 | - | - | 84.4 |
| E6-1 | 56.5 | 0.3 | - |
| E6-2 | - | - | 99 |
| E6 | - | - | 72.9 |
| E7-1 | 55.3 | 0.19 | - |
| E7-2 | - | - | 99.1 |
| E7 | - | - | 72.8 |
| E8-1 | 55.2 | 0.19 | - |
| E8-2 | - | - | 75.2 |
| E8 | - | - | 70.5 |
| E9-1 | 77.9 | 1.8 | - |
| E9-2 | - | - | 86.5 |
| E9 | - | - | 83.5 |
| E10-1 | 78 | 1.8 | - |
| E10-2 | - | - | 85.5 |
| E10 | - | - | 82.5 |
| E11-1 | 77.9 | 1.79 | - |
| E11-2 | - | - | 87.8 |
| E11 | - | - | 84.8 |
| E 12-1 | 79 | 1.95 | - |
| E12-2 | - | - | 81.5 |
| E12 | - | - | 78.5 |
| E13-1 | 77 | 1.5 | - |
| E13-2 | - | - | 89.5 |
| E13 | - | - | 84 |
| E14-1 | 77.8 | 1.8 | - |
| E14-2 | - | - | 87.5 |
| E14 | - | - | 84.4 |

From data of Table 1, it might be seen that, compared with Embodiment 1, due to the excessive addition of the titanium dioxide in Embodiments 6 and 7, the titanium dioxide was accumulated, causing an effective specific surface area achieving a sunlight reflection effect to decrease, and thus finally causing the overall reflectivity of the encapsulation adhesive film to reduce.

Compared with the Embodiment 1, due to excessive addition of the azo pigment B27 in the Embodiments 6 and 7, the light transmittance of the infrared high-transmittance adhesive film layer for sunlight reduced.

In the Embodiment 8, the light transmittance of the infrared high-transmittance adhesive film layer for the sunlight and the reflectivity of the infrared high-transmittance adhesive film layer and the encapsulation adhesive film are largely affected by changing the use amounts and types of the cross-linking agents and assistant cross-linking agents.

Photovoltaic module PID test: front layer adhesive films all used F406PS transparent adhesive films; P-type double-sided cells of a manufacturer A were used; the photovoltaic module PID test was tested according to IEC TS2804-1:2015; a test condition was: 85 °C, 85%RH, and a -1500V constant direct-current voltage; after 192h, and power attenuation before and after the photovoltaic module PID test was determined, and test results were listed in Table 2.

**Table 2**

| Module | Photovoltaic module PID 192h power attenuation |
|---|---|
| PV-1 | 2.36 |
| PV-2 | 2.54 |
| PV-3 | 2.24 |
| PV-4 | 2.33 |
| PV-5 | 2.42 |
| PV-6 | 2.29 |
| PV-7 | 2.22 |
| PV-8 | 4.25 |
| PV-9 | 2.28 |
| PV-10 | 2.29 |
| PV-11 | 2.21 |
| PV-12 | 2.79 |
| PV-13 | 2.17 |
| PV-14 | 2.86 |
| PV-D1 | 6.92 |

It might be seen from the above description that, in the above embodiments of the present disclosure, the following technical effects were realized.

The light transmittance of the infrared high-transmittance adhesive film layer of the encapsulation adhesive film provided in the present disclosure for the light within the wavelength range of 700-1100 nm was greater than 55%, and for the light within the wavelength range of 400-700 nm was less than 2%, and the reflectivity of the infrared high-reflection adhesive film layer for the light within the wavelength range of 700-1100 nm was greater than 75%. Therefore, by using the encapsulation adhesive film as an encapsulation adhesive film on a back side of a cell piece, black exterior appearance of the photovoltaic module could be realized so as to reduce light pollution, and sunlight could also be utilized to the maximum extent, such that the overall photoelectric conversion efficiency of the photovoltaic module was improved, thereby improving the efficiency and service life of a solar cell. Furthermore, by applying the encapsulation adhesive film to BIPV, both the aesthetics of a building and the efficiency of the photovoltaic module might be taken into consideration.

From PID comparison testing, it might be found that, in the encapsulation adhesive film provided in the present disclosure, because the infrared high-reflection adhesive film layer used an inorganic filler, the anti-PID performance of the photovoltaic module of the P-type double-sided cell was improved, and in particular, when the infrared high-reflection adhesive film layer used a pure titanium dioxide filler, the anti-PID performance was significantly improved compared to that of a conventional transparent adhesive film, which was expected to be related to the electronegativity of the titanium dioxide or the titanium dioxide had the function of delaying the entry of sodium ions into the encapsulation adhesive film.

The above are only the preferred embodiments of the present disclosure and are not intended to limit the present disclosure. For those skilled in the art, the present disclosure may have various modifications and variations. Any modifications, equivalent replacements, improvements and the like made within the spirit and principle of the present disclosure all fall within the scope of protection of the present disclosure.

## Claims

1. An encapsulation adhesive film, comprising an infrared high-transmittance adhesive film layer, and an infrared high-reflection adhesive film layer, which is stacked on the infrared high-transmittance adhesive film layer, wherein the light transmittance of the infrared high-transmittance adhesive film layer for light within a wavelength range of 700-1100 nm is greater than 55%; the light transmittance of the infrared high-transmittance adhesive film layer for light within a wavelength range of 400-700 nm is less than 2%; and the reflectivity of the infrared high-reflection adhesive film layer for the light within the wavelength range of 700-1100 nm is greater than 75%.

2. The encapsulation adhesive film according to claim 1, wherein the light transmittance of the infrared high-transmittance adhesive film layer for the light within the wavelength range of 700-1100 nm is greater than 58%; and the light transmittance of the infrared high-transmittance adhesive film layer for the light within the wavelength range of 400-700 nm is less than 1%.

3. The encapsulation adhesive film according to claim 1, wherein the reflectivity of the infrared high-reflection adhesive film layer for the light within the wavelength range of 700-1100 nm is greater than 85%.

4. The encapsulation adhesive film according to any one of claims 1 to 3, wherein the reflectivity of the encapsulation adhesive film for the light within the wavelength range of 700-1100 nm is greater than 70%.

5. The encapsulation adhesive film according to any one of claims 1 to 3, wherein the infrared high-transmittance adhesive film layer comprises a pigment; the pigment is selected from any one or more of fullerene and derivatives thereof, a direct fast dye, a direct diazo dye, a direct cross-linking dye, and an azo dye containing complex metal;
by weight, the infrared high-transmittance adhesive film layer comprises 100 parts of first olefin resin, 0.01-10 parts of the pigment, 0.01-0.1 part of a first coupling agent, 0.01-0.3 parts of a first cross-linking agent, and 0.01-0.3 parts of a first assistant cross-linking agent; and
the first olefin resin is selected from any one or more of ethylene-vinyl acetate, an ethylene-octene copolymer, an ethylene-α olefin copolymer, an ethylene-methyl methacrylate copolymer, an ethylene-methacrylic acid ionic polymer, and a metallocene-catalyzed ethylene butene copolymer.

6. The encapsulation adhesive film according to any one of claims 1 to 3, wherein, by weight, the infrared high-reflection adhesive film layer comprises 100 parts of second olefin resin, 5-40 parts of a filler, 0.01-0.1 part of a second coupling agent, 0.01-0.3 parts of a second cross-linking agent, and 0.01-0.3 parts of a second assistant cross-linking agent;
the second olefin resin is selected from any one or more of ethylene-vinyl acetate, an ethylene-α olefin copolymer, an ethylene-methyl methacrylate copolymer, an ethylene-methacrylic acid ionic polymer, and a metallocene-catalyzed ethylene butene copolymer;
the filler is selected from any one or more of titanium dioxide, talcum powder, silica, aluminum hydroxide, magnesium hydroxide, aluminum oxide, boehmite, mica, kaolin, calcium carbonate, calcium metasilicate, aluminum nitride, and boron nitride; and a particle size of the filler is 0.4-2.0 µm.

7. The encapsulation adhesive film according to any one of claims 1 to 3, wherein the thickness of the infrared high-transmittance adhesive film layer is 80-300 µm; the infrared high-transmittance adhesive film layer is a pre-crosslinked film; and a pre-crosslinked degree of the infrared high-transmittance adhesive film layer is 5-50%.

8. The encapsulation adhesive film according to any one of claims 1 to 3, wherein the thickness of the infrared high-reflection adhesive film layer is 120-500 µm; the infrared high-reflection adhesive film layer is a pre-crosslinked film; and a pre-crosslinked degree of the infrared high-reflection adhesive film layer is 10-70%.

9. A photovoltaic module, comprising a front transparent encapsulation layer, a first encapsulation adhesive film layer, a cell piece array, a second encapsulation adhesive film layer, and a back encapsulation layer, wherein the second encapsulation adhesive film layer is the encapsulation adhesive film according to any one of claims 1 to 8.

10. The photovoltaic module according to claim 9, wherein an infrared high-transmittance adhesive film layer of the encapsulation adhesive film is in contact with a cell piece of the photovoltaic module.
